# EUROPÄISCHE PATENTSCHRIFT

(11) **EP 3 418 776 B1**
(45) Veröffentlichungstag und Bekanntmachung des Hinweises auf die Patenterteilung: **05.01.2022**
(21) Anmeldenummer: 17177142.1
(22) Anmeldetag: 21.06.2017
(51) Int. Cl.: G01T 1/17

(54) **STRAHLENDETEKTOR SOWIE VERFAHREN ZUM BETRIEB EINES STRAHLENDETEKTORS**
RADIATION DETECTOR AND METHOD FOR OPERATING SAME
DÉTECTEUR DE RAYONS ET SON PROCÉDÉ DE FONCTIONNEMENT

(43) Veröffentlichungstag der Anmeldung: 26.12.2018
(73) Patentinhaber: Siemens Healthcare GmbH, 91052 Erlangen (DE)
(72) Erfinder: Göderer, Edgar, 91301 Forchheim (DE); Hosemann, Michael, 91056 Erlangen (DE)

(56) Entgegenhaltungen:
- WO-A1-2017/036619
- WO-A2-2007/144589
- DE-A1- 2 926 902
- US-A1- 2015 108 354
- US-A1- 2016 313 456
- US-B2- 9 316 749
- YE POLONNIKOV D ET AL: "A METHOD OF SELECTING THE TYPE OF ACTIVE THREE-POLE FOR AMPLIFIERS WITH PROGRAMMED TRANSFER RATIO", TELECOMMUNICATIONS AND RADIO ENGINEERING, SCRIPTA TECHNICA,INC., NEW YORK, NY, US, vol. 39/40, no. 9, 1 September 1985 (1985-09-01), pages 81-83, XP009520992, ISSN: 0040-2508

## Beschreibung

Strahlendetektor sowie Verfahren zum Betrieb eines Strahlendetektors.

Die Erfindung betrifft einen Strahlendetektor sowie ein Verfahren zum Betrieb eines Strahlendetektors.

Bildgebende Vorrichtungen in der medizinischen Diagnostik, insbesondere in der Röntgendiagnostik weisen typischerweise einen Strahlendetektor auf, insbesondere einen Röntgenstrahlungsdetektor, kurz: Röntgendetektor. Unter bildgebenden Vorrichtungen werden vorliegend allgemein Röntgenvorrichtungen und speziell Computertomographen verstanden.

Röntgendetektoren sind üblicherweise als Szintillatordetektoren oder als photonenzählende Detektoren mit Direktkonverter ausgebildet.

Szintillatordetektoren weisen ein Szintillatormaterial auf. Szintillatormaterialien werden durch eine Bestrahlung mit Röntgenstrahlung angeregt und emittieren die Anregungsenergie in Form von Licht. Das emittierte Licht wird anschließend beispielsweise mittels als Photodioden ausgebildeten Sensorelementen in ein elektrisches Sensorsignal umgewandelt und in einer, üblicherweise mehrere Auswerteelemente aufweisenden, Auswerteeinheit zu einem Ausgangssignal, insbesondere in einen elektrischen Strom, auch Signalstrom genannt, ausgewertet. Hierzu weist üblicherweise jedes Auswerteelement eine anwendungsspezifische integrierte Schaltung (ASIC) auf. Das Ausgangssignal kann auch beispielsweise einen Stromimpuls aufweisen, jedoch treten derartige Stromimpulse nur bei photonenzählenden Direktkonvertern auf.

Häufig weisen Szintillatordetektoren mehrere Szintillatorelemente auf, welche nach Art eines Arrays angeordnet sind. Analog weisen die Sensorelemente und die Auswerteelemente ebenfalls eine Anordnung nach Art eines Arrays auf.

Strahlendetektoren mit Direktkonvertern weisen üblicherweise ein Halbleitermaterial, beispielsweise einen Halbleiter auf Cadmiumtellurid-Basis (CdTe) auf, welcher auf ihn auftreffende Strahlung, beispielsweise Röntgenstrahlung in ein elektrisches Ausgangssignal, insbesondere in einen Stromimpuls umwandelt.

Beide Detektorarten weisen jeweils eine matrixartige Anordnung sowohl der Sensorelemente als auch der Auswerteelemente auf. In diesem Zusammenhang werden die Sensorelemente auch als Sensorpixel und die Auswerteelemente auch als Auswertepixel bezeichnet.

Zur Auswertung der Signalströme weist ein Sensorelement typischerweise eine elektrische Verbindung mit einem ihm zugeordneten Auswerteelement mittels eines elektrischen Verbindungselements, beispielsweise einem elektrischen Leitungselement, auf. Die Signalströme werden typischerweise in der Auswerteeinheit zu einem Ausgangssignal ausgewertet und in einer, sich üblicherweise an die Auswerteeinheit anschließenden, Signalverarbeitungseinheit, beispielsweise in ein Bild umgewandelt.

Aufgrund dessen, dass mittels der Auswerteeinheit oftmals kleine Ströme ausgewertet werden und elektrische Leitungen typischerweise parasitäre Effekte, beispielsweise parasitäre Kapazitäten, aufweisen, sind die Sensoreinheit und die Auswerteeinheit häufig flächengleich ausgebildet und übereinander angeordnet, um eine kleinstmögliche Länge der elektrischen Verbindungselemente zu realisieren. Unter kleinen Strömen werden vorliegend elektrische Ströme mit einem Wert im Bereich von 1pA bis 1µA (pro Auswerteelement) verstanden. Zur Auswertung derartiger kleiner Signalströme weist typischerweise jedes Auswerteelement weiterhin beispielsweise eine Verstärkereinheit zur Verstärkung der Signalströme und somit auch zur Verstärkung des Ausgangssignals auf.

Unter flächengleicher Ausbildung wird vorliegend verstanden, dass jeweils die Sensoreinheit und die Auswerteeinheit eine Länge und eine Breite aufweisen, die jeweils einen bis auf eine Toleranz von <20%, insbesondere <10% gleichen Wert aufweisen. Analog hierzu verhält sich die Anzahl und Verteilung der einzelnen Elemente (Sensorelemente und Auswerteelemente), sowie eine Flächenform, beispielsweise nach Art eines Rechtecks, der Elemente (Sensorelemente und Auswerteelemente). Weiterhin sind die Sensoreinheit und die Auswerteeinheit formschlüssig aufeinander angeordnet. Hierdurch ist erreicht, dass jedem Sensorelement ein Auswerteelement zugeordnet ist, welches dem Sensorelement "gegenüber" liegt. Somit reduziert sich eine Länge der elektrischen Verbindung zwischen einem Sensorelement und dem ihm zugeordneten Auswerteelement. Hierdurch ist insbesondere die bereits erwähnte kürzest mögliche elektrische Verbindung zwischen den Sensorelementen und den Auswerteelementen garantiert.

Aufgrund der kurzen elektrischen Verbindung weist diese typischerweise geringe parasitäre Effekte auf, da insbesondere eine Länge einer elektrischen Leitung mit der Höhe von parasitären Effekten progressiv korreliert ist. Unter progressiver Korrelation wird vorliegend verstanden, dass mit einem zunehmendem Wert einer Länge einer elektrischen Verbindung, insbesondere einer elektrischen Leitung, in der Leitung auftretende parasitäre Effekte, beispielsweise der Wert einer parasitären Kapazität der elektrischen Leitung, ebenfalls einen zunehmenden Verlauf zeigen.

Insbesondere die Auswerteeinheit weist oftmals ein unvorteilhaftes Flächenverhältnis zwischen einer Gesamtfläche der Auswerteeinheit und durch Auswerteelemente "aktiv" genutzter Fläche der Auswerteeinheit auf. Hierunter ist vorliegend zu verstehen, dass ein Großteil der Fläche der Auswerteeinheit aus schaltungstechnischer Sicht nicht im eigentlichen Zweck der Auswerteeinheit genutzt wird. Dies führt zu einer unerwünscht unvorteilhaften Elementendichte. Unter Elementendichte wird vorliegend eine Anzahl an Elementen (Sensorelemente und Auswerteelement) in Bezug auf eine Fläche auf der die Elemente (Sensorelemente und Auswerteelement) angeordnet sind verstanden.

Um diesem unvorteilhaften Flächenverhältnis vorzubeugen, weist die Auswerteeinheit eine Fläche auf, welche ausschließlich durch die einzelnen Flächen der Auswerteelemente gebildet ist. Somit reduziert sich die Gesamtfläche des Auswerteeinheit auf die Summe der Flächen der Auswerteelemente. Die Auswerteinheit weist somit üblicherweise, bis auf fertigungsbedingte Toleranzen, keine schaltungstechnisch "ungenutzte" Fläche auf.

Folglich weist die Gesamtfläche der Auswerteeinheit einen kleineren Wert auf, als die Gesamtfläche der Sensoreinheit. D.h. die Sensoreinheit und die Auswerteeinheit sind vorliegend nicht flächengleich. Infolgedessen weist zumindest ein Teil der elektrischen Verbindungen zwischen den einzelnen Sensorelementen und den zugeordneten Auswerteelementen, insbesondere in einem Randbereich der Sensor- und Auswerteeinheit eine unterschiedliche Länge auf.

Aufgrund der unterschiedlichen Längen der elektrischen Verbindungen, weisen die auftretenden parasitären Effekte, insbesondere die auftretenden parasitären Kapazitäten, unterschiedliche Werte auf. Dies wirkt sich nachteilig auf beispielsweise eine Pulsform des elektrischen Ausgangssignals, ein Rauschen des verstärkten Ausgangssignals sowie insbesondere auf eine Gleichmäßigkeit des Rauschens über die einzelnen Auswerteelemente aus. Folglich ist hierdurch auch die Bildqualität des Strahlendetektors nachteilig betroffen. Derartige Effekte, beispielsweise das bereits genannte Rauschen, führen beispielsweise zu einer ungleichmäßigen Bildqualität und beeinträchtigen somit den diagnostischen Wert der Röntgenaufnahme.

In der US 9 316 749 B2 wird ein Strahlendetektor sowie ein Verfahren zur Anpassung von Leitungskapazitäten beschrieben.

Der Strahlendetektor weist mehrere Empfangspixel auf, welche über zumindest einen Signalleiter miteinander verbunden sind. Der zumindest eine Signalleiter ist mit mehreren Stellelementen zur Anpassung der Leitungskapazität verbunden.

Die US 2015/0108354 A1 beschreibt einen Röntgenstrahlendetektor mit einem Lichtsensor. Der Lichtsensor weist ein Array aus mehreren Pixeln auf. Jedes Pixel weist eine Diodenanordnung sowie eine Kondensatoranordnung zur Bereitstellung von variabler Speicherkapazität auf, die in Abhängigkeit einer eingestellten Strahlendosis von einer Kontrolleinheit eingestellt wird, die die Diodenanordnung und die Kondensatoranordnung ansteuert.

Der US 2016/0313456 A1 ist ein Hochenergie-Strahlendetektor sowie ein Betriebsverfahren für einen Hochenergie-Strahlendetektor zu entnehmen, bei dem in Abhängigkeit von Betriebsparametern räumliche Bildkorrekturen vorgenommen werden.

Die Druckschrift DE 29 26 902 A1 offenbart eine Dosismesseinrichtung mit einem Strahlendetektor, einem Verstärker und einer dem Verstärker zugeordneten Integrationsstufe und einem die Integrationsstufe bei einem voreinstellbaren aufintegrierten Wert zurückstellenden Steuerelement, wobei ein Messwandler den am Strahlendetektor herrschenden, dessen Messeigenschaften beeinflussenden Umwelteinflüssen ausgesetzt ist und die Ausgänge der Messwandler über je einen, der Einflussnahme der jeweiligen Messgröße auf die angezeigte Dosis angepassten Verstärker dem Eingang des Steuerelements für die Rückstellung der Integrationsstufe im Sinne einer Beeinflussung der Ansprechschwelle zugeordnet sind.

In D. Ye. Polonnikov et al: "A METHOD OF SELECTING THE TYPE OF ACTIVE THREE-POLE FOR AMPLIFIERS WITH PROGRAMMED TRANSFER RATIO", TELECOMMUNICATIONS AND RADIO ENGINEERING, SCRIPTA TECHNICA, INC., NEW YORK, NY, US, Bd. 39/40, Nr. 9 (1985-09-01), Seiten 81-83, XP009520992, ISSN: 0040-2508 wird eine Verstärkerkonfigurationen offenbart mit einer Regelung der Verstärkung eines negativen Rückkopplungspfades (NFB), wobei für eine Kompensation des durch eine parasitäre Kapazität C_{P} (einschließlich der Ausgangskapazität des Multiplexers, der Verdrahtungskapazität usw.) eingeführten Pols ein Kondensator C_{FB} enthalten sein kann.

Die Druckschrift WO 2007/144589 A2 offenbart ein Gerät zur Detektion von hochenergetischer Strahlung, welches eine variable Kapazität aufweisen kann. Die variable Kapazität ist zwischen dem Schaltungskontakt, welcher mit dem CdTe Detektorsubstrat verbunden ist, und dem Referenzpotential für das Schaltungssubstrat angeordnet.

Ausgehend hiervon liegt der Erfindung die Aufgabe zugrunde, einen Strahlendetektor anzugeben, bei dem Artefakte aufgrund solcher parasitärer Effekte zumindest verringert sind.

Die Aufgabe wird erfindungsgemäß gelöst durch einen Strahlendetektor, insbesondere einen Röntgendetektor mit den Merkmalen des Anspruchs 1 sowie einem Verfahren zum Betrieb eines Strahlendetektors mit den Merkmalen des Anspruchs 11.

Vorteilhafte Ausgestaltungen, Weiterbildungen und Varianten sind Gegenstand der Unteransprüche.

Die im Hinblick auf den Strahlendetektor aufgeführten Vorteile und bevorzugten Ausgestaltungen sind sinngemäß auf das Verfahren zu übertragen und umgekehrt.

Der Strahlendetektor weist eine Sensoreinheit mit mehreren Sensorelementen zur Erzeugung eines Sensorsignals auf. Weiterhin weist der Strahlendetektor eine Auswerteeinheit mit mehreren Auswerteelementen auf. Hierbei entsprechen sich bevorzugt die Anzahl der Sensorelemente und die Anzahl der Auswerteelemente. Mittels der Auswerteelemente ist eine Auswertung des Sensorsignals und eine Umwandlung des Sensorsignals in ein Ausgangssignal ermöglicht. Zur Verarbeitung des Ausgangssignals weist der Strahlendetektor weiterhin eine sich an die Auswerteeinheit anschließende Signalverarbeitungseinheit auf.

Jedes Auswerteelement ist einem Sensorelement zugeordnet und hierzu mittels eines elektrischen Verbindungselements, beispielsweise einer elektrischen Leitung, mit dem jeweils zugeordneten Sensorelement elektrisch leitend verbunden. Bei den elektrischen Verbindungselementen handelt es sich beispielsweise um eine strangförmige elektrische Leitung, bevorzugt um eine Leiterbahn auf einer Platine. Das elektrische Verbindungselement weist eine Leitungskapazität, beispielsweise eine parasitäre Kapazität, sowie eine individuelle Länge auf. Unter Leitungskapazität wird vorliegend allgemein beispielsweise ein Kapazitätsbelag, eine Fringe-Kapazität und/oder eine parasitäre Kapazität verstanden.

Unter parasitärer Kapazität wird allgemein eine meist unerwünschte Kapazität zwischen zwei elektrischen Leitungselementen verstanden, welche aufgrund ihrer Ladung und des Abstandes zueinander eine Kapazität nach Art eines Plattenkondensators aufweisen, welche sich (elektrisch) störend auswirkt. Im Speziellen wird unter Leitungskapazität insbesondere eine parasitäre Kapazität bereits genannter Art zwischen den elektrischen Verbindungselementen verstanden.

Allgemein sind individuelle Kapazitäten von Leitungen durch mehrere verschiedene Kapazitäten charakterisiert, beispielsweise Kapazitäten gegen Masse und / oder Kapazitäten gegen andere Leitungen. Im Hinblick auf die Erfindung sind insbesondere die parasitären Kapazitäten gegen Masse und parasitäre Kapazitäten gegen unmittelbare Nachbarleitungselemente eines jeweiligen Leitungselements relevant. Unter Masse wird vorliegend allgemein das elektrische Nullpotential verstanden.

Wie eingangs beschrieben, weist die Fläche der Sensoreinheit des Strahlendetektors einen anderen, insbesondere größeren, Wert auf, als die Fläche der Auswerteeinheit. Aufgrund dessen weisen die elektrischen Verbindungselemente, abhängig einer Position der durch sie miteinander verbundenen Sensor- und Auswerteelemente unterschiedliche, individuelle Längen auf. Bevorzugt weisen die elektrischen Verbindungselemente eine Länge mit einem Wert im Bereich zwischen 10µm und 300µm in einem Mittenbereich der Sensor- und der Auswerteeinheit und einen Wert im Bereich zwischen 1mm und 4cm in einem Randbereich der Sensor- und der Auswerteeinheit auf. Insbesondere weist sowohl die Sensoreinheit als auch die Auswerteeinheit eine Form nach Art eines planaren Rechtecks auf. Unter planar ist vorliegend eine plattenförmige Ausgestaltung zu verstehen. Aus Gründen der Symmetrie und einer vereinfachten Herstellung weist zumindest ein Teil der elektrischen Verbindungselemente beispielsweise die gleiche Länge auf.

Weiterhin ist der Wert der Leitungskapazität, insbesondere der Wert der parasitären Kapazität, progressiv mit dem Wert der Länge des elektrischen Verbindungselements korreliert. Insofern weisen die Leitungskapazitäten von zumindest einem Teil der elektrischen Verbindungselemente aufgrund der unterschiedlichen, individuellen Längen der elektrischen Verbindungselemente jeweils einen unterschiedlichen Wert auf. Mit anderen Worten: Zumindest ein Teil der elektrischen Verbindungselemente weist aufgrund ihrer unterschiedlichen, individuellen Längen, jeweils eine unterschiedliche, Leitungskapazität auf.

Die unterschiedlichen Leitungskapazitäten stören aufgrund ihrer unterschiedlichen Werte die über die elektrischen Verbindungselemente übertragenen Ausgangssignale, wodurch diese unterschiedliche Signaleigenschaften aufweisen. Unter Signaleigenschaften werden vorliegend im Speziellen eine Pulsform (insbesondere eine Pulsbreite und eine Pulshöhe) und / oder ein Rauschen der Ausgangssignale verstanden. Weiterhin beeinflusst die zusätzliche Leitungskapazität das Rauschen des mittels der Verstärkereinheit verstärkten Ausgangssignals.

Weiterhin weist jedes Teil der Auswerteelemente ein zusätzliches Stellelement, beispielsweise eine Kapazität auf, wobei sich die Stellelemente verschiedener Auswerteelemente unterscheiden. Die Stellelemente sind derart gewählt, dass die in Abhängigkeit der unterschiedlichen Leitungskapazitäten variierenden Signaleigenschaften der von der Auswerteeinheit an die Signalverarbeitungseinheit übertragenen Ausgangssignale angeglichen sind.

Mit anderen Worten: Um ein homogenes Antwortverhalten der Auswerteeinheit, insbesondere hinsichtlich der bereits beschriebenen Signaleigenschaften (beispielsweise der Pulsbreite) und / oder des Rauschens des Ausgangssignals zu erreichen, hat es sich als vorteilhaft erwiesen, die unterschiedlichen Leitungskapazitäten derart anzugleichen, dass die unterschiedlichen elektrischen Verbindungselemente vorzugsweise eine gleiche Gesamtkapazität aufweisen. Unter Antwortverhalten wird vorliegend allgemein eine Veränderung eines Signals, welche aufgrund einer Verarbeitung, beispielsweise auf Basis einer Übertragungsfunktion, innerhalb eines signalverarbeitenden Bauteils (vorliegend im Speziellen ein jeweiliges Auswerteelement) auftritt verstanden.

D.h., dass jedes elektrische Verbindungselement nach der Angleichung, unabhängig seiner Länge, die gleiche Leitungskapazität (in diesem Fall gilt: Leitungskapazität = Gesamtkapazität) aufweist. Um einen derartigen Gesamtkapazitätswert zu erreichen, weisen die Stellelemente der verschiedenen elektrischen Verbindungselemente bevorzugt jeweils einen Ausgleichskapazitätswert auf, welcher einer Differenz zwischen der Gesamtkapazität und der jeweiligen Leitungskapazität des elektrischen Verbindungselementes entspricht.

Aufgrund dessen, dass mittels der Stellelemente lediglich eine Erweiterung, insbesondere eine Erhöhung, eines Wertes der unterschiedlichen Leitungskapazitäten ermöglicht ist, dient das elektrische Verbindungselement, dessen Leitungskapazität den größten Wert aufweist, als einen Mindestwert für den Wert der Gesamtkapazität.

Das folgende Beispiel dient einem besseren Verständnis:
Ein Strahlendetektor weist drei Sensorelemente und drei Auswerteelemente auf. Jeweils ein Sensorelement ist mittels eines elektrischen Verbindungselementes mit einem Auswerteelement elektrisch verbunden. Insofern weist der Strahlendetektor drei elektrische Verbindungselemente auf, welche jeweils eine unterschiedliche, individuelle Länge aufweisen. Aufgrund der unterschiedlichen Längen der elektrischen Verbindungselemente, weisen diese jeweils unterschiedliche Leitungskapazitäten auf. Ein erstes elektrisches Verbindungselement weist eine Leitungskapazität mit einem Wert von 200fF, ein zweites elektrisches Verbindungselement weist eine Leitungskapazität mit einem Wert von 350fF und ein drittes elektrisches Verbindungselement weist eine Leitungskapazität mit einem Wert von 500fF auf. Der Wert der Gesamtkapazität ist somit durch das dritte elektrische Verbindungselement - weil dieses von allen drei Leitungskapazitäten den höchsten Wert aufweist - auf einen Wert (Mindestwert) von zumindest 500fF bestimmt. Als Wert für die Gesamtkapazität wird beispielsweise dieser Wert von 500fF definiert. Um die unterschiedlichen Leitungskapazitäten der elektrischen Verbindungselemente an die Gesamtkapazität anzugleichen, weisen die drei elektrischen Verbindungselemente jeweils ein Stellelement mit einer Ausgleichskapazität auf. Das Stellelement des ersten elektrischen Verbindungselements weist eine Ausgleichskapazität mit einem Wert von 300fF auf (Differenz zwischen Gesamtkapazitätswert und Leitungskapazitätswert: 500fF - 200fF = 300fF). Das Stellelement des zweiten elektrischen Verbindungselements weist eine Ausgleichskapazität mit einem Wert von 150fF auf (Differenz zwischen Gesamtkapazitätswert und Leitungskapazitätswert: 500fF - 350fF = 150fF).

Durch die Stellelemente ist insbesondere eine Angleichung der Signaleigenschaften der Ausgangssignale erreicht, was sich als vorteilhaft hinsichtlich der Bildqualität des Strahlendetektors erwiesen hat. Weiterhin sind mittels der Angleichung, insbesondere der Homogenisierung, der Signaleigenschaften der Ausgangsignale bildqualitätsmindernden Effekten vorgebeugt. Derartige Effekte sind gegenwärtig der sogenannte Pile-Up-Effekt und/oder der sogenannte Paralyse-Effekt. Unter Pile-Up-Effekt wird vorliegend ein Effekt verstanden, bei dem beispielsweise zwei rechteckförmige Signalpulse an sich zugewandten Seiten derart berühren, dass eine Signalverarbeitungseinheit die beiden Signalpulse als einen einzigen Signalpuls mit einer Gesamtdauer der beiden Einzelpulse detektiert. Unter dem Paralyse-Effekt wird vorliegend der Effekt verstanden, bei dem eine Zähleinheit des Detektors zu zählende Pulse aufgrund einer Überlappung dieser Pulse, beispielsweise durch den Pile-Up-Effekt, verpasst. Während die Zähleinheit einen Puls "zählt" ist für weitere Zählereignisse "paralysiert", wodurch weniger Pulse gezählt werden, als tatsächlich als Ereignis auftreten.

Der Paralyse-Effekt tritt insbesondere bei hohen Pulsfrequenzen auf. Unter hohen Pulsfrequenzen werden vorliegend Frequenzen von Pulsen verstanden, bei denen ein mittlerer Abstand zweier Pulse einen kleineren Wert aufweist als beispielsweise ein Zehnfaches einer mittleren Halbwertsbreite eins Pulses.

Besonders bevorzugt weist zumindest ein Teil der zusätzlichen Stellelemente eine unterschiedliche Ausgleichskapazität auf. Der Vorteil ist, dass hierdurch auf eine - schaltungstechnisch betrachtet - einfache Weise ein Ausgleich der Leitungskapazitäten nach bereits beschriebener Art in den elektrischen Verbindungselementen erreicht ist.

Zur Anpassung der Stellelemente an die unterschiedlichen Werte der Leitungskapazitäten, insbesondere der parasitären Kapazitäten, sind die Stellelemente erfindungsgemäß in ihrem Wert einstellbar. Unter einstellbar wird vorliegend verstanden, dass die Stellelemente einen zumindest beispielsweise im Rahmen eines Einbaus in den Strahlendetektor variierbaren Ausgleichskapazitätswert aufweisen.

Jedes Auswerteelement weist eine anwendungsspezifische integrierte Schaltung (ASIC) mit einem Verstärkerelement auf. Der Vorteil der Ausgestaltung liegt darin, dass mittels der ASIC eine speziell anwendungsspezifische Schaltung zur Auswertung des Sensorsignals realisiert ist. Hierdurch ist es insbesondere ermöglicht, spezifische Eigenschaften und/oder Anwendungsdetails des Strahlendetektors, beispielsweise die Art des Strahlendetektors (Szintillatordetektor oder direktkonvertierender Detektor) in die Schaltung zu integrieren und somit die Bildqualität des Detektors zu erhöhen.

Das Verstärkerelement weist einen Signaleingang, einen Rücckopplungseingang sowie einen Signalausgang auf. Weiterhin weist das Verstärkerelement bevorzugt ein resistives Rücckopplungselement, beispielsweise eine Impedanz auf, welches den Signalausgang mit dem Rückkopplungseingang verbindet. Alternativ weist das Verstärkerelement ein kapazitives Rücckopplungselement, beispielsweise einen Kondensator, oder eine Kombination aus einem resistiven und einem kapazitiven Rücckopplungselement auf. Unter Kombination wird vorliegend speziell ein Rückkopplungselement verstanden, welches sowohl ein resistives als auch ein kapazitives Bauteil aufweist. Hinsichtlich der Ausgestaltung des Verstärkerelements ist eine Homogenisierung der Signaleigenschaften allgemein mittels Verstärkerelements bekannter Art realisierbar.

Die Angleichung der Leitungskapazitäten und die hieraus resultierende Homogenisierung der Signaleigenschaften der Ausgangssignale erfolgt durch eine Anordnung des Stellelements zwischen dem Signalausgang und dem Rückkopplungseingang eines jeden Auswerteelements. Das Stellelement ist im Rückkopplungselement eines jeden Auswerteelements angeordnet. Ein wesentlicher Aspekt und Vorteil ist vorliegend darin zu sehen, dass in jedem Auswerteelement mittels der Anordnung des Stellelementes im Rückkopplungselement zusätzlich zur Angleichung der Leitungskapazität eine Angleichung der Signaleigenschaften des Ausgangssignals mittels der Rückkopplung ermöglicht ist. Mit anderen Worten: Durch die Anordnung des Stellelements im Rückkopplungselement ist eine genauere Angleichung der Signaleigenschaften der Ausgangssignale im Vergleich zu einer Anordnung des Stellelements am Signaleingang des Verstärkerelements erreicht. Insbesondere hinsichtlich des homogenen Antwortverhaltens, d.h. hinsichtlich eines homogenen Ausgangssignals zur weiteren Verarbeitung durch die Signalverarbeitungseinheit hat sich diese Ausgestaltungsvariante als vorteilhaft erwiesen.

Bevorzugt ist das Stellelement auf Basis einer Simulation und/oder auf Basis eines Einmessvorgangs eingestellt. Unter Einmessvorgang ist beispielsweise eine Einspeisung repräsentativer Messsignale in die Auswerteeinheit zu verstehen, deren Ausgangssignale hinsichtlich ihrer Signaleigenschaften (insbesondere ihrer Pulsbreite) bekannt sind. Die erzeugten Ausgangsignale werden anschließend erfasst und hinsichtlich ihrer gemessenen Signaleigenschaften mit den bekannten Ausgangsignalen verglichen. Eine Abweichung der gemessenen Werte für die Signaleigenschaften, beispielsweise Pulsbreite und/oder Pulshöhe dient anschließend einer Einstellung des Stellelements.

Die Einstellung des Stellelements mittels der Simulation und/oder des Einmessvorgangs ist beispielsweise einmalig im Rahmen der Entwicklung und/oder einer (Erst-)Inbetriebnahme des Strahlendetektors realisiert. Dies wird nicht beansprucht. Einmessdaten und/oder Einstelldaten sind beispielsweise in der jeweiligen ASIC eines Auswerteelements gespeichert. Alternativ ist durch eine geeignete Auswahl an unterschiedlichen Stellelementen eine Angleichung der Signaleigenschaften der Ausgangssignale erreicht.

Alternativ oder ergänzend erfolgt die Einstellung des Stellelements beispielsweise temperatur- und/oder nutzungsabhängig. Hierbei wird vorliegend im Gegenteil zu der bereits erwähnten einmaligen Einstellung eine alternierende Einstellung des Stellelements hinsichtlich beispielsweise von einem Arzt gewünschter Bereiche eines Körpers eines Patienten vorgenommen. D.h. die Einstellung der Stellelemente wird von einem Bediener vorgenommen, beispielsweiseabhängig von dem zu untersuchenden Objekt, von dem eine Bildaufnahme erstellt wird. Unter Objekt wird vorliegend vorzugsweise ein menschliches Organ verstanden; alternativ wird unter Objekt allgemein ein zu röntgender Gegenstand, beispielsweise im Rahmen einer Kontrolle an einem Flughafen oder im Rahmen einer Untersuchung eines Materialstückes, verstanden.

Aufgrund dessen, dass verschiedene Objekte verschiedene Strahlencharakteristiken und somit verschiedene Energieschwellen aufweisen, erfolgt die Einstellung in Abhängigkeit einer für eine Aufnahme, beispielsweise der Lunge, des Patienten zu erwartenden Energieschwelle des Sensorsignals. Somit ist eine nutzungsspezifisch optimale Homogenisierung der Pulsform und somit eine optimale Bildqualität erreicht. Die nutzungsspezifische Einstellung des Stellelements erfolgt beispielsweise im Rahmen einer jeden Behandlungsvorbereitung beim Hochfahren oder Vorbereiten des Strahlendetektors.

Experimentelle Messungen haben ergeben, dass die Leitungskapazitäten der elektrischen Verbindungselemente insbesondere unterschiedliche Werte bevorzugt in einem Bereich zwischen 10fF und 10pF, insbesondere in einem Bereich von 50fF bis 1pF und speziell in einem Bereich von 100fF bis 500fF aufweisen.

Bevorzugt weist das Stellelement einen Kondensator, beispielsweise einen Fringe-Kondensator auf. Der Fringe-Kondensator weist beispielsweise in einem Querschnitt insbesondere eine Form nach Art zweier ineinander verzahnten Kämme auf. Der Vorteil ist, dass mittels des Kondensators eine einfache und kostengünstige Realisierung der Ausgleichskapazität erreicht ist. Alternativ weist das Stellelement einen Plattenkondensator auf.

Um den Ausgleich der Leitungskapazitäten zu ermöglichen, sind die Kondensatoren der Stellelemente zweckdienlicherweise derart ausgebildet und/oder eingerichtet, dass sie unterschiedliche Ausgleichskapazitäten - analog zu den Werten der Leitungskapazitäten - bevorzugt mit Werten in einem Bereich zwischen 10fF und 10pF, insbesondere in einem Bereich von 50fF bis 1pF und speziell in einem Bereich von 100fF bis 500fF aufweisen.

Bevorzugt weisen die unterschiedlichen Ausgleichskapazitäten der Kondensatoren der Stellelemente der in einem Randbereich der Auswerteeinheit angeordneten Auswerteelemente einen geringeren Wert der Ausgleichskapazitäten als in einem Mittenbereich auf.

Gemäß einer zweckmäßigen Weiterbildung weisen die unterschiedlichen Ausgleichskapazitäten der Kondensatoren der Stellelemente der in einem Randbereich der Auswerteeinheit angeordneten Auswerteelemente einen Wert im Bereich von 1fF bis 100fF auf.

Analog weisen die unterschiedlichen Ausgleichskapazitäten der Kondensatoren der Stellelemente der in einem Mittenbereich der Auswerteeinheit angeordneten Auswerteelemente einen Wert im Bereich von 350fF bis 600fF auf.

Dieser Weiterbildung liegt die Überlegung zugrunde, dass im Randbereich der Auswerteeinheit geringere Kapazitätswerte seitens der Ausgleichskapazitäten eingestellt werden müssen als beispielsweise im Mittenbereich der Auswerteeinheit.

Unter Randbereich wird vorliegend eine Teilfläche der Auswerteeinheit verstanden, welche sich von den Außenkanten der Auswerteinheit beispielsweise nach Art eins umlaufenden Rahmens in Richtung zu einem Zentrum der Auswerteeinheit erstreckt. Der Randbereich überdeckt beispielsweise bis zu 1/3, oder bis zur Hälfte der Gesamtfläche der Auswerteeinheit. Unter Mittenbereich wird vorliegend analog die Differenz der Gesamtfläche der Auswerteeinheit und der Fläche des Randbereiches verstanden.

Bevorzugt weist das elektrische Verbindungselement ein Umverdrahtungselement nach Art eines Interposers auf. Somit ist eine technisch einfache und kostengünstige elektrische Verbindung zwischen den Sensorelementen und den Auswerteelementen erreicht.

Alternativ weist beispielsweise die Sensoreinheit eine integrierte Verdrahtung auf. Unter integrierter Verdrahtung ist vorliegend beispielsweise eine Drahtlage mit mehreren elektrischen Leitungen zu verstehen, welche an einer Oberfläche des Sensorelements angeordnet ist und die Sensorelemente mit den zugeordneten Auswerteelementen elektrisch verbindet. Bevorzugt ist der Strahlendetektor als ein photonenzählender Röntgendetektor ausgebildet. Der Vorteil der Ausbildung ist darin zu sehen, dass sich die bereits beschriebenen Effekte (Pile-Up-Effekt und der Paralyse-Effekt) insbesondere bei photonenzählenden Röntgendetektoren negativ auswirken. Durch die Angleichung der Signaleigenschaften der Ausgangssignale ist insbesondere bei einem derartigen Röntgendetektor den Effekten vorgebeugt.

Die Aufgabe wird erfindungsgemäß weiterhin gelöst durch ein Verfahren zum Betrieb eines Strahlendetektors mit den Merkmalen des Anspruchs 11.

Ausführungsbeispiele werden nachfolgend anhand der Figuren näher erläutert. Diese zeigen teilweise in stark vereinfachten Darstellungen:
- FIG 1: eine Querschnittsdarstellung einer gegenüber einer Auswerteeinheit angeordneten Sensoreinheit innerhalb eines Strahlendetektors,
- FIG 2: ein grob vereinfachtes Blockschaltbild einer Schaltung eines Strahlendetektors gemäß einem nicht beanspruchten Beispiel, sowie
- FIG 3: ein grob vereinfachtes Blockschaltbild einer Schaltung eines Strahlendetektors gemäß der beanspruchten Erfindung.

In den Figuren sind gleichwirkende Teile mit den gleichen Bezugszeichen dargestellt.

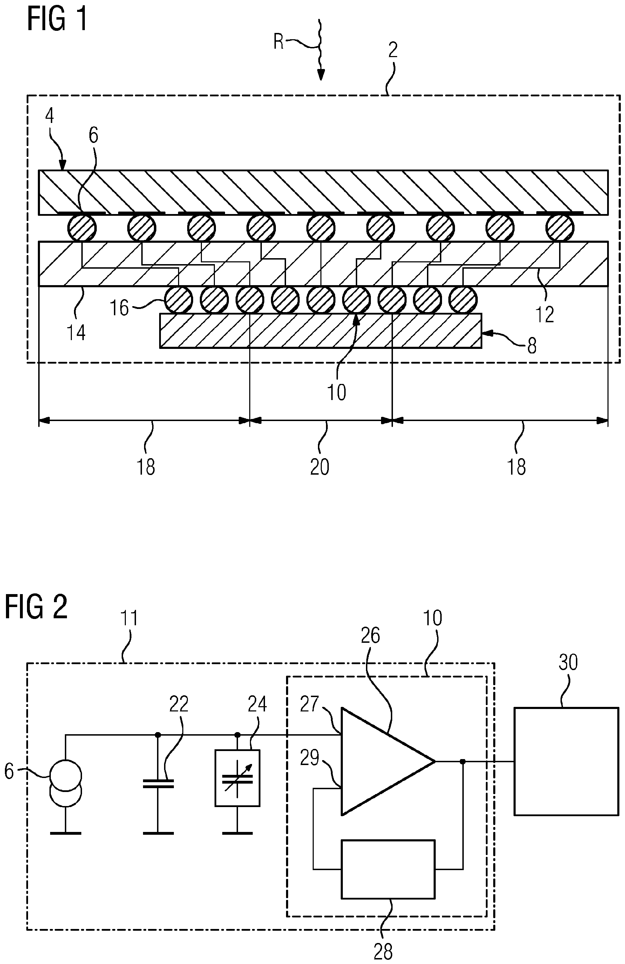

In FIG 1 ist eine Sensoreinheit 4 mit mehreren Sensorelementen 6 sowie eine Auswerteeinheit 8 mit mehreren Auswerteelementen 10 dargestellt. Sowohl die Sensoreinheit 4 als auch die Auswerteeinheit 8 sind gemeinsam in einem Strahlendetektor 2 angeordnet. Im Ausführungsbeispiel ist der Strahlendetektor 2 als ein photonenzählender Röntgendetektor, beispielsweise als ein Direktkonverter ausgebildet. Derartige Strahlendetektoren sind beispielsweise in der medizinischen Diagnostik zu Untersuchungszwecken und/oder in sicherheitsempfindlichen Bereichen, beispielsweise in Sicherheitszonen eines Flughafens zur Überprüfung von Gepäckstücken und/oder Personen eingesetzt. Im Betrieb wird der Strahlendetektor mit Röntgenstrahlung R bestrahlt. Der Strahlendetektor ist insbesondere Teil einer Röntgenvorrichtung, die neben dem Strahlendetektor noch eine im Ausführungsbeispiel nicht dargestellte Strahlenquelle aufweist.

Die Auswerteeinheit 8 ist im Ausführungsbeispiel als eine anwendungsspezifische integrierte Schaltung (ASIC) ausgebildet.

Dies ermöglicht eine explizit auf eine Anwendung - vorliegend: Röntgendiagnostik - spezifizierte Realisierung der Schaltung.

Aus Gründen einer vereinfachten Darstellung und einer für FIG 1 fehlenden Relevanz ist auf eine explizite Darstellung des Strahlendetektors 2 in FIG 1 verzichtet.

Im Ausführungsbeispiel weist sowohl die Sensoreinheit 4 als auch die Auswerteeinheit 8 eine Ausgestaltung nach Art eines Arrays auf. Die Anzahl der Auswerteelemente 10 entspricht hierbei der Anzahl der Sensorelemente 6. Somit ist jedem Sensorelement 6 ein Auswerteelement 10 zugeordnet, wodurch der Strahlendetektor mehrere, im Ausführungsbeispiel neun, Sensorelement-Auswerteelement-Paare (SAP) 11 aufweist.

Zur elektrischen Verbindung weist jedes SAP 11 ein elektrisches Verbindungselement 12 auf. Das elektrische Verbindungselement 12 weist beispielsweise eine strangförmige elektrische Leitung mit zumindest einem Leitungselement aus einem elektrisch leitenden Material, beispielsweise Kupfer, Aluminium oder Wolfram, auf oder ist aus einem derartigen Material gebildet. Alternativ ist das elektrische Verbindungselement als eine Leiterbahn beispielsweise auf einer Platine ausgebildet. Im Ausführungsbeispiel sind die SAPs 11 mittels eines Umverdrahtungselementes, insbesondere mittels eines Interposers 14, elektrisch verbunden.

Im Ausführungsbeispiel sind die Sensoreinheit 4 und die Auswerteeinheit 8 als ein Ball-Grid-Array (BGA) ausgebildet, wodurch das elektrische Verbindungselement 12 zusätzlich elektrische Verbindungs-Balls 16 aufweist. Die Verbindungs-Balls 16 sind im Ausführungsbeispiel insbesondere an Anschlüssen des Interposers 14 angeordnet. Im Ausführungsbeispiel weisen die Verbindungs-Balls 16 einen Durchmesser mit einem Wert im Bereich von 20µm bis 50µm auf.

Die Auswerteeinheit 8 weist im Ausführungsbeispiel eine um beispielsweise zumindest mehr als 10%, insbesondere um mehr als 40% kleinere Fläche auf als die Sensoreinheit 4.

Somit variiert eine Länge der elektrischen Verbindungselemente 12 innerhalb des Interposers 14 in Abhängigkeit einer lokalen Positionierung der SAP 11.

Insbesondere in einem Randbereich 18 der Sensor- und der Auswerteeinheit 4,8 weisen die elektrischen Verbindungselemente 12 eine größere Länge auf als beispielsweise in einem Mittenbereich 20. Im Ausführungsbeispiel weisen die elektrischen Verbindungen inklusive der Länge der Verbindungs-Balls 16 im Mittenbereich 22 eine Länge mit einem Wert im Bereich von 10µm bis 300µm und im Randbereich 18 eine Länge mit einem Wert im Bereich von 1mm bis 4cm auf.

Aufgrund der unterschiedlichen Längen der elektrischen Verbindungselemente 12 weisen diese unterschiedliche parasitäre Effekte, insbesondere Leitungskapazitäten 22, beispielsweise parasitäre Kapazitäten auf.

Die Leitungskapazitäten 22 führen zu unterschiedlichen Signaleigenschaften der einzelnen Ausgangssignale der Auswerteeinheit 8. Bei einer weiteren Verarbeitung, beispielswiese zu einem (Röntgen-)Bild, führen die unterschiedlichen Signaleigenschaften zu unerwünschten Beeinträchtigungen der Bildqualität.

Zu einem Angleichen der unterschiedlichen Signaleigenschaften, insbesondere hinsichtlich einer Pulsform und / oder eines Rauschens der Ausgangssignale ist in FIG2 ein grob vereinfachtes Blockschaltbild einer Schaltung eines Strahlendetektors 2 gemäß einem nicht beanspruchten Beispiel dargestellt. Im Beispiel weist jedes Auswerteelement 10 eine derartige Schaltung auf.

Die Schaltung gemäß diesem Beispiel weist die Sensoreinheit 4, eine Leitungskapazität 22 ein Stellelement 24 sowie ein Verstärkerelement 26 mit einem Rückkopplungselement 28 und eine Signalverarbeitungseinheit 30 auf. Das Verstärkerelement 26 weist weiterhin einen Signaleingang 27, einen Signalausgang 25 und einen Rückkopplungseingang 29 auf. Das Rückkopplungselement 28 verbindet im Ausführungsbeispiel den Signalausgang 25 mit dem Rückkopplungseingang 29.

Zur Erläuterung der Schaltung wird im Folgenden kurz auf den Zweck der Schaltung, insbesondere des Stellelements 24, eingegangen:
Das Stellelement 24 weist im Beispiel einen einstellbaren Kondensator, beispielsweise einen Fringe-Kondensator, auf. Alternativ weist das Stellelement 24 einen herkömmlichen Plattenkondensator auf.

Unter Einstellbar ist vorliegend zu verstehen, dass der Wert der Kapazität des Kondensators beispielsweise im Rahmen eines Einmessvorgangs bei der Inbetriebnahme des Strahlendetektors 2 derart auf die Leitungskapazität 22 des jeweiligen elektrischen Verbindungselementes 12 eingestellt wird, sodass sich aufgrund einer Parallelschaltung der individuellen Kapazität 22 und des Stellelementes 24 die Kapazitätswerte der beiden Kapazitäten 22,24 auf einen gemeinsamen Ausgleichskapazitätswert addieren.

Die Einstellung von zumindest einem Teil der übrigen Stellelemente 24 erfolgt ebenfalls derart, dass sich durch eine Parallelschaltung der beiden Kapazitäten 22,24 der gleiche Ausgleichskapazitätswert ergibt. Somit ist erreicht, dass die Ausgangssignale der Auswerteelemente die gleichen Signaleigenschaften aufweisen, welche beispielsweise bei der anschließenden Verarbeitung des Ausgangssignals innerhalb der Signalverarbeitungseinheit 30 zu einer qualitativ gleichförmigeren Bildgenerierung führt als mehrere unterschiedliche Signaleigenschaften der Ausgangssignale.

Hierzu ist das Stellelement 24 im nicht beanspruchten Beispiel am Signaleingang 27 angeordnet, insbesondere angeschlossen.

Das Verstärkerelement 26 ist beispielsweise als ein Operationsverstärker ausgebildet. Alternativ ist das Verstärkerelement als ein Transimpedanzverstärker ausgebildet.

Als Rückkopplungselement 28 weist das Verstärkerelement 26 im Ausführungsbeispiel eine Impedanz, beispielsweise einen ohmschen Widerstand und zusätzlich in der zweiten Ausgestaltungsvariante beispielsweise einen Kondensator auf.

Die Signalverarbeitungseinheit 30 ist beispielsweise zur Energieschwellenquantifizierung des Ausgangssignals ausgebildet.

Durch die in FIG 2 dargestellte Schaltungsvariante ist somit eine Angleichung der Signaleigenschaften der Ausgangssignale insbesondere durch einen Ausgleich der unterschiedlichen individuellen Kapazitäten 22 erreicht.

Gemäß der beanspruchten Erfindung ist ein Angleichen der Signaleigenschaften der Ausgangssignale durch eine Anordnung des Stellelements 24 innerhalb des Rückkopplungselements 28 erreicht.

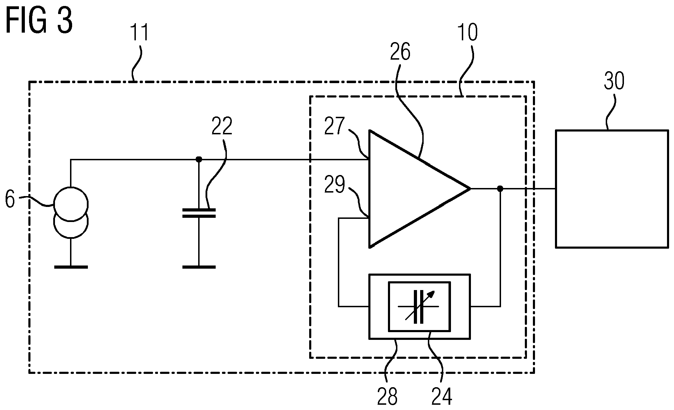

Ein grob vereinfachtes Blockschaltbild einer Schaltung eines Strahlendetektors gemäß einer derartigen zweiten Ausgestaltungsvariante ist in FIG 3 dargestellt. Analog zu der in FIG dargestellten Schaltung, ist die in FIG 3 gezeigte Schaltung ebenfalls jeweils alternativ in jedem Auswerteelement im Ausführungsbeispiel angeordnet.

Die Schaltung des in FIG 3 dargestellten erfindungsgemäßen Ausführungsbeispiel weist analog zu der in FIG 1 dargestellten Ausgestaltung ebenfalls die Sensoreinheit 4, eine Leitungskapazität 22, welche in Abhängigkeit der Länge des elektrischen Verbindungselements 12 einen unterschiedlichen Wert aufweist, das Verstärkerelement 26 sowie die Rückkopplungseinheit 28 und die Signalverarbeitungseinheit 30 auf.

Das Stellelement 24 ist gemäß dieser Ausgestaltungsvariante jedoch innerhalb des Rückkopplungselementes 28 angeordnet und somit am Rückkopplungseingang 29 des Verstärkerelements 26 angeschlossen. Hierdurch ist eine Angleichung der Signaleigenschaften der Ausgangssignale insbesondere hinsichtlich einer rückgekoppelten Angleichung erreicht. Mit anderen Worten: Zur Angleichung der Signaleigenschaften der Ausgangssignale wird gemäß der zweiten Ausgestaltungsvariante zusätzlich zu einem Ausgleich der individuellen Kapazitäten 22 eine Approximation hinsichtlich einer tolerierbaren Abweichung von dem Ausgleichskapazitätswert ermöglicht, sofern bei einer Abweichung von dem Ausgleichskapazitätswert (und somit einem bewussten Verzicht auf exakt ausgeglichene Leitungskapazitäten) ein Mehrwert hinsichtlich der angeglichenen Signaleigenschaften der Ausgangssignale erreicht wird.

## Patentansprüche

1. Strahlendetektor (2), insbesondere Röntgendetektor, welcher aufweist
- eine Sensoreinheit (4) mit mehreren Sensorelementen (6) zur Erzeugung eines Sensorsignals,
- eine Auswerteeinheit (8) mit mehreren Auswerteelementen (10) zur Auswertung und Umwandlung des Sensorsignals in ein Ausgangssignal sowie
- eine sich an die Auswerteeinheit (8) anschließende Signalverarbeitungseinheit (30) zur Verarbeitung des Ausgangssignals, wobei
- jedes Auswerteelement (10) mit einem zugeordneten Sensorelement (6) über jeweils ein elektrisches Verbindungselement (12) verbunden ist, das eine Leitungskapazität (22) sowie eine individuelle Länge aufweist,
- jedes Auswerteelement (10) eine anwendungsspezifische integrierte Schaltung mit einem Verstärkerelement (26) mit einem Signaleingang (27) und mit einem Signalausgang (25) aufweist,
- die Leitungskapazitäten (22) unterschiedlich sind und dadurch zu unterschiedlichen Signaleigenschaften der Ausgangssignale führen und
- weiterhin jedes der Auswerteelemente (10) ein zusätzliches Stellelement (24) aufweist- und sich die Stellelemente (24) verschiedener Auswerteelemente (10) unterscheiden und derart gewählt sind, dass die unterschiedlichen Signaleigenschaften der Ausgangssignale angeglichen sind,
**dadurch gekennzeichnet, dass**
- das Verstärkerelement (26) neben dem Signaleingang (27) einen Rückkopplungseingang (29) und weiterhin ein Rückkopplungselement (28) aufweist, welches den Signalausgang (25) mit dem Rückkopplungseingang (29) verbindet und dass
- das Stellelement (24) zwischen dem Signalausgang (25) und dem Rückkopplungseingang (29) im Rückkopplungselement (28) angeordnet ist, wobei das Stellelement (24) einstellbar ist und die Einstellung des Stellelements (24) alternierend und in Abhängigkeit einer zu erwartenden Energieschwelle des Sensorsignals erfolgt.

2. Strahlendetektor (2) nach dem vorhergehenden Anspruch, **dadurch gekennzeichnet, dass** die zusätzlichen Stellelemente (24) jeweils eine Ausgleichskapazität aufweisen und sich die Ausgleichskapazitäten in ihrem Wert unterscheiden.

3. Strahlendetektor (2) nach dem vorhergehenden Anspruch, **dadurch gekennzeichnet, dass** die Einstellung der Stellelemente (24) temperatur- und/oder nutzungsabhängig erfolgt.

4. Strahlendetektor (2) nach einem der Ansprüche 2 bis 3, **dadurch gekennzeichnet, dass** das Stellelement (24) auf Basis einer Simulation und/oder eines Einmessvorgangs eingestellt ist.

5. Strahlendetektor (2) nach einem der vorhergehenden Ansprüche,
**dadurch gekennzeichnet, dass** die Leitungskapazitäten (22) bevorzugt jeweils einen unterschiedlichen Wert im Bereich von 10fF bis 10pF, insbesondere im Bereich zwischen 50fF und 1pF und speziell in einem Bereich von 100fF bis 500fF aufweisen.

6. Strahlendetektor (2) nach einem der vorhergehenden Ansprüche und nach Anspruch 2, **dadurch gekennzeichnet, dass** das Stellelement (24) einen Kondensator mit einer Ausgleichskapazität aufweist.

7. Strahlendetektor (2) nach dem vorhergehenden Anspruch, **dadurch gekennzeichnet, dass** die Ausgleichskapazität bevorzugt einen Wert im Bereich von 10fF bis 10pF, insbesondere im Bereich zwischen 50fF und 1pF und speziell einen Wert in einem Bereich von 100fF bis 500fF aufweist.

8. Strahlungsdetektor (2) nach einem der beiden vorhergehenden Ansprüche, **dadurch gekennzeichnet, dass** die Ausgleichskapazität des in einem Randbereich (18) angeordneten Kondensators eines Auswerteelements (10) eine geringere Kapazität als in einem Mittenbereich aufweist.

9. Strahlungsdetektor (2) nach einem der Ansprüche 6 bis 8, **dadurch gekennzeichnet, dass** die Ausgleichskapazität des in einem Randbereich (18) angeordneten Kondensators eines Auswerteelements (10) eine Kapazität mit einem Wert im Bereich von 1fF bis 300fF aufweist, und / oder
die Ausgleichskapazität des in einem Mittenbereich (20) angeordneten Kondensators eines Auswerteelements (10) eine Kapazität mit einem Wert im Bereich von 200fF bis 1000fF aufweist.

10. Strahlendetektor (2) nach einem der vorhergehenden Ansprüche, **dadurch gekennzeichnet, dass** das elektrische Verbindungselement (12) ein Umverdrahtungselement nach Art eines Interposers (14) aufweist.

11. Verfahren zum Betrieb eines Strahlendetektors (2), insbesondere Röntgendetektor, welcher aufweist
- eine Sensoreinheit (4) mit mehreren Sensorelementen (6) zur Erzeugung eines Sensorsignals,
- eine Auswerteeinheit (8) mit mehreren Auswerteelementen (10) zur Auswertung und Umwandlung des Sensorsignals in ein Ausgangssignal sowie
- eine sich an die Auswerteeinheit (8) anschließende Signalverarbeitungseinheit (30) zur Verarbeitung des Ausgangssignals, wobei
- jedes Auswerteelement (10) mit einem zugeordneten Sensorelement (6) über jeweils ein elektrisches Verbindungselement (12) verbunden ist, das eine Leitungskapazität (22) sowie eine individuelle Länge aufweist,
- jedes Auswerteelement (10) eine anwendungsspezifische integrierte Schaltung mit einem Verstärkerelement (26) mit einem Signaleingang (27) und mit einem Signalausgang (25) aufweist,
- die Leitungskapazitäten (22) unterschiedlich sind und dadurch zu unterschiedlichen Signaleigenschaften der Ausgangssignale führen und
- weiterhin jedes der Auswerteelemente (10) ein zusätzliches Stellelement (24) aufweist
- und sich die Stellelemente (24) verschiedener Auswerteelemente (10) unterscheiden und derart gewählt werden, dass die unterschiedlichen Signaleigenschaften der Ausgangssignale angeglichen werden,
**dadurch gekennzeichnet, dass**
- das Verstärkerelement (26) neben dem Signaleingang (27) einen Rückkopplungseingang (29) und weiterhin ein Rückkopplungselement (28) aufweist, welches den Signalausgang (25) mit dem Rückkopplungseingang (29) verbindet und, dass
- das Stellelement (24) zwischen dem Signalausgang (25) und dem Rückkopplungseingang (29) im Rückkopplungselement (28) angeordnet ist, wobei das Stellelement (24) einstellbar ist und die Einstellung des Stellelements (24) alternierend und in Abhängigkeit einer zu erwartenden Energieschwelle des Sensorsignals erfolgt.

## Claims

1. Radiation detector (2), in particular an X-ray detector, which has
- a sensor unit (4) having a plurality of sensor elements (6) for generating a sensor signal,
- an evaluation unit (8) having a plurality of evaluation elements (10) for evaluating and converting the sensor signal into an output signal, and
- a signal processing unit (30) directly following the evaluation unit (8) for the purpose of processing the output signal, wherein
- each evaluation element (10) is connected to an associated sensor element (6) via a respective electrical interconnect element (12) which has an interconnect capacitance (22) and an individual length,
- each evaluation element (10) has an application-specific integrated circuit having an amplifier element (26) with a signal input (27) and a signal output (28),
- the interconnect capacitances (22) are different and as a result lead to different signal properties being exhibited by the output signals, and
- each of the evaluation elements (10) furthermore have an additional actuating element (24), and the actuating elements (24) of different evaluation elements (10) are different from one another and are chosen such that the different signal properties of the output signals are aligned,
**characterised in that**
- in addition to the signal input (27), the amplifier element (26) has a feedback input (29) and in addition a feedback element (28), which connects the signal output (25) to the feedback input (29) and
- the actuating element (24) is arranged between the signal output (25) and the feedback input (29), in the feedback element (28), wherein the actuating element (24) can be set and the setting of the actuating element (24) takes place on an alternating basis and as a function of a likely energy threshold of the sensor signal.

2. Radiation detector (2) according to the preceding claim, **characterised in that** the additional actuating elements (24) each have a balancing capacitance and the balancing capacitances are different from one another in terms of their value.

3. Radiation detector (2) according to the preceding claim, **characterised in that** the setting of the actuating element (24) takes place as a function of temperature and/or usage.

4. Radiation detector (2) according to one of claims 2 to 3,**characterised in that** the actuating element (24) is set on the basis of a simulation and/or a calibration process.

5. Radiation detector (2) according to one of the preceding claims,
**characterised in that** the interconnect capacitances (22) preferably each have a different value in the range of lOfF to 10pF, in particular in the range between 50fF and 1pF, and specifically in a range of 100fF to 500fF.

6. Radiation detector (2) according to one of the preceding claims and according to claim 2, **characterised in that** the actuating element (24) has a capacitor having a balancing capacitance.

7. Radiation detector (2) according to the preceding claim, **characterised in that** the balancing capacitance preferably has a value in the range of lOfF to 10pF, in particular in the range between 50fF and 1pF, and specifically a value in a range of 100fF to 500fF.

8. Radiation detector (2) according to one of the two preceding claims, **characterised in that** the balancing capacitance of the capacitor of an evaluation element (10) arranged in a peripheral region (18) has a lower capacitance than in a central region.

9. Radiation detector (2) according to one of claims 6 to 8, **characterised in that**
the balancing capacitance of the capacitor of an evaluation element (10) arranged in a peripheral region (18) has a capacitance with a value in the range of 1fF to 300fF, and/or
the balancing capacitance of the capacitor of an evaluation element (10) arranged in a central region (20) has a capacitance with a value in the range of 200fF to 1000fF.

10. Radiation detector (2) according to one of the preceding claims, **characterised in that** the electrical interconnect element (12) has a wiring rerouting element in the manner of an interposer (14).

11. Method for operating a radiation detector (2), in particular an X-ray detector, which has
- a sensor unit (4) having a plurality of sensor elements (6) for generating a sensor signal,
- an evaluation unit (8) having a plurality of evaluation elements (10) for evaluating and converting the sensor signal into an output signal, and
- a signal processing unit (30) directly following the evaluation unit (8) for the purpose of processing the output signal, wherein
- each evaluation element (10) is connected to an associated sensor element (6) via a respective electrical interconnect element (12) which has an interconnect capacitance (22) as well as an individual length,
- each evaluation element (10) has an application-specific integrated circuit having an amplifier element (26) with a signal input (27) and a signal output (28),
- the interconnect capacitances (22) are different and as a result lead to different signal properties being exhibited by the output signals, and
- each of the evaluation elements (10) furthermore have an additional actuating element (24), and
- the actuating elements (24) of different evaluation elements (10) are different from one another and are chosen such that the different signal properties of the output signals are aligned,
**characterised in that**
- in addition to the signal input (27), the amplifier element (26) has a feedback input (29) and in addition a feedback element (28), which connects the signal output (25) to the feedback input (29) and
- the actuating element (24) is arranged between the signal output (25) and the feedback input (29), in the feedback element (28), wherein the actuating element (24) can be set and the setting of the actuating element (24) takes place on an alternating basis and as a function of a likely energy threshold of the sensor signal.

## Revendications

1. Détecteur (2) de rayonnement, notamment détecteur de rayons x, qui a
- une unité (4) de capteur ayant plusieurs éléments (6) de capteur pour la production d'un signal de capteur,
- une unité (8) d'exploitation ayant plusieurs éléments (10) d'exploitation pour l'exploitation et la transformation du signal du capteur en un signal de sortie, ainsi que
- une unité (30) du traitement du signal, se raccordant à l'unité (8) d'exploitation, pour le traitement du signal de sortie,
dans lequel
- chaque élément d'exploitation est relié à un élément (6) de capteur associé par respectivement un élément (12) de liaison électrique, qui a une capacité (22) de ligne ainsi qu'une longueur individuelle,
- chaque élément (10) d'exploitation a un circuit intégré spécifique à une application comprenant un élément (26) amplificateur ayant une entrée (27) de signal et une sortie (25) de signal,
- les capacités (22) de ligne sont différentes et donnent ainsi des propriétés de signal différentes des signaux de sortie, et
- en outre chacun des éléments (10) d'exploitation à un élément (24) supplémentaire de réglage et les éléments (24) de réglage d'éléments (10) d'exploitation différents se distinguent et sont choisis de manière à égaliser les propriétés de signal différentes des signaux de sortie, **caractérisé en ce que**
- l'élément (26) amplificateur a, outre l'entrée (27) de signal, une entrée (29) de réaction et en outre un élément (28) de réaction, qui relie la sortie (25) du signal à l'entrée (29) de réaction.
et **en ce que**
- l'élément (24) de réglage est disposé entre la sortie (25) du signal et l'entrée (29) de réaction dans l'élément (28) de réaction, dans lequel l'élément (24) de réglage est réglable et le réglage de l'élément (24) de réglage a lieu en alternance et en fonction d'un seuil d'énergie à escompter du signal de capteur.

2. Détecteur (2) de rayonnement suivant la revendication précédente,
**caractérisé en ce que**
les éléments (24) supplémentaires de réglage ont chacun une capacité de compensation et les capacités de compensation se distinguent par leur valeur.

3. Détecteur (2) de rayonnement suivant la revendication précédente,
**caractérisé en ce que**
le réglage des éléments (24) de réglage a lieu en fonction de la température et/ou de l'utilisation.

4. Détecteur (2) de rayonnement suivant l'une des revendications 2 à 3,
**caractérisé en ce que**
l'élément (24) de réglage est réglé sur la base d'une simulation et/ou d'une opération d'étalonnage.

5. Détecteur (2) de rayonnement suivant l'une des revendications précédentes,
**caractérisé en ce que**
les capacités (22) de ligne ont de préférence respectivement une valeur différente allant de 10fF jusqu'à 10pF, notamment dans la plage comprise entre 50fF et 1 pF, et spécialement dans une plage allant de 100fF jusqu'à 500fF.

6. Détecteur (2) de rayonnement suivant l'une des revendications précédentes et suivant la revendication 2,
**caractérisé en ce que**
l'élément (24) de réglage a un condensateur ayant une capacité de compensation.

7. Détecteur (2) de rayonnement suivant la revendication précédente,
**caractérisé en ce que**
la capacité de compensation a de préférence une valeur dans la plage allant de 10fF jusqu'à 10pF, notamment dans la plage comprise entre 50fF et 1pF, et spécialement une valeur dans une plage allant de 100fF jusqu'à 500fF.

8. Détecteur (2) de rayonnement suivant l'une des deux revendications précédentes,
**caractérisé en ce que**
la capacité de compensation du condensateur, monté dans la partie (18) de bord d'un élément (10) d'exploitation, a une capacité plus petite que dans une partie au milieu.

9. Détecteur (2) de rayonnement suivant l'une des revendications 6 à 8,
**caractérisé en ce que**
la capacité du condensateur, monté dans une partie (18) de bord d'un élément (10) d'exploitation, a une capacité ayant une valeur dans la plage allant de 1fF jusqu'à 300fF et/ou la capacité de compensation du condensateur, monté dans une partie (20) au milieu d'un élément (10) d'exploitation, a une capacité ayant une valeur dans la plage allant de 200fF jusqu'à 1000fF.

10. Détecteur (2) de rayonnement suivant l'une des revendications précédentes,
**caractérisé en ce que**
l'élément de liaison électrique a un élément de recâblage à la manière d'un interposeur (14).

11. Procédé pour faire fonctionner un détecteur (2) de rayonnement, notamment un détecteur de rayons x, qui a
- une unité (4) de capteur ayant plusieurs éléments (6) de capteur pour la production d'un signal de capteur,
- une unité (8) d'exploitation ayant plusieurs éléments (10) d'exploitation pour l'exploitation et la transformation du signal du capteur en un signal de sortie, ainsi que
- une unité (30) du traitement du signal, se raccordant à l'unité (8) d'exploitation, pour le traitement du signal de sortie,
dans lequel
- chaque élément d'exploitation est relié à un élément (6) de capteur associé par respectivement un élément (12) de liaison électrique, qui a une capacité (22) de ligne ainsi qu'une longueur individuelle,
- chaque élément (10) d'exploitation a un circuit intégré spécifique à une application comprenant un élément (26) amplificateur ayant une entrée (27) de signal et une sortie (25) de signal,
- les capacités (22) de ligne sont différentes et donnent ainsi des propriétés de signal différentes des signaux de sortie,
- et on distingue et on choisit les éléments de réglage d'éléments (10) d'exploitation différents de manière à égaliser les propriétés de signal différentes des signaux de sortie,
**caractérisé en ce que**
- l'élément (26) amplificateur a, outre l'entrée (27) de signal, une entrée (29) de réaction et en outre un élément (28) de réaction, qui relie la sortie (25) du signal à l'entrée (29) de réaction.
et **en ce que**
- l'élément (24) de réglage est disposé entre la sortie (25) du signal et l'entrée (29) de réaction dans l'élément (28) de réaction, dans lequel l'élément (24) de réglage est réglable et le réglage de l'élément (24) de réglage a lieu en alternance et en fonction d'un seuil d'énergie à escompter du signal de capteur.
